# FASCICULE DE BREVET EUROPEEN

(11) **EP 2 896 127 B1**
(45) Date de publication et mention de la délivrance du brevet: **28.09.2016**
(21) Numéro de dépôt: 13767031.1
(22) Date de dépôt: 30.08.2013
(51) Int. Cl.: H03K 3/53, H01T 9/00

(54) **GÉNÉRATEUR D'IMPULSIONS DE FORTE PUISSANCE DE FORME SENSIBLEMENT QUADRANGULAIRE À PENTE RÉGLABLE**
GENERATOR FÜR VIERECKIGE HOCHLEISTUNGSPULSE MIT EINSTELLBARER FLANKRENSTEILHEIT
GENERATOR FOR RECTANGULAR HIGHPOWER PULSES WITH ADJUSTABLE SLOPE

(30) Priorité: 14.09.2012 FR 1258662
(43) Date de publication de la demande: 22.07.2015
(73) Titulaire: ITHPP, 46500 Thegra (FR)
(72) Inventeur: VOLKOV, Sergey, Tomsk 634029 (RU); ALEXEENKO, Vitaly, Tomsk 634021 (RU); KONDRATIEV, Sergey, Tomsk 634061 (RU); BAYOL, Frédéric, 46120 Themines (FR); DEMOL, Gauthier, 46400 Saint Cere (FR)
(74) Mandataire: Cabinet BARRE LAFORGUE & associés
(86) Numéro de dépôt international: PCT/FR2013/052003
(87) Numéro de publication internationale: WO 2014/041276

(56) Documents cités:
- DE-A1- 19 639 023
- DE-A1-102006 033 374
- US-A1- 2007 296 342

## Description

L'invention concerne un générateur d'impulsions de forte puissance de la famille des LTD (« Linear Transformer Driver »), et plus particulièrement un tel générateur capable de fournir des impulsions de forme quadrangulaire dont la pente de la partie supérieure de l'impulsion est réglable.

Le domaine technologique des « hautes puissances pulsées » fait usage de générateurs capables de fournir des impulsions extrêmement brèves d'une tension de plusieurs millions de volts et d'une intensité de plusieurs millions d'ampères. On connaît par exemple des générateurs, dits générateurs de Marx comme décrit dans le document DE 10 2006 033 374 A1, dans lesquelles des condensateurs sont chargés en parallèle et déchargés en série au moyen d'éclateurs commandés, appelés commutateurs. De tels commutateurs sont connus, par exemple, du brevet français FR 2 879 842 de la demanderesse auquel on pourra se référer pour de plus amples détails sur le commutateur.

Plus récemment, on a utilisé des générateurs de type « Linear Transformer Driver » ou LTD, constitués d'une pluralité de modules comportant chacun un commutateur placé en série entre deux condensateurs, les condensateurs étant chargés en parallèle et déchargés en série lorsque le commutateur est fermé, l'impulsion de courant ainsi générée s'additionnant aux impulsions de courant de tous les autres modules pour former une impulsion de forte puissance. Cependant, ces impulsions ont en général une forme quasi sinusoïdale et, pour certaines applications, le besoin s'est fait sentir d'avoir des impulsions présentant une forme sensiblement rectangulaire ou trapézoïdale.

On connaît de la publication « Square pulse linear transformer driver » de KIM, MAZARAKIS et al. publiée le 3 avril 2012 dans la revue Physical Review Spécial Topics - Accelerators and Beams n° 15, un générateur de type LTD comportant deux série de modules de puissance, une première série de modules standards comportant une paire de condensateurs d'une première valeur de capacité adaptés pour produire une impulsion d'une première fréquence et une deuxième série de modules modifiés comportant une paire de condensateurs d'une deuxième valeur de capacité adaptés pour produire une impulsion de fréquence triple de la première fréquence lors de la fermeture du commutateur. La combinaison de ces deux impulsions dans une charge fournit, en application du théorème de Fourier, une impulsion résultante sensiblement rectangulaire, comportant une rampe de montée, un plateau et une rampe de descente. Les auteurs ont toutefois suggéré qu'une telle impulsion comportant un plateau présentant une pente ascendante ou descendante pourrait être mieux adaptée pour certaines applications telles que la fusion de l'hydrogène (machines à striction axiale), la radiographie rapide (rayonnements X intenses), ou encore les micro-ondes de forte puissance.

Cette publication suggère que la pente du plateau pourrait être réglée en modifiant l'inductance des modules modifiés, par exemple en modifiant la largeur des conducteurs reliant les condensateurs à la charge. Néanmoins, une telle solution présente des désavantages : l'augmentation de la largeur des conducteurs qui conduit à une baisse de l'inductance du module, est limitée pour des raisons d'encombrement et d'isolement entre les conducteurs. De même, la diminution de la largeur des conducteurs dégrade les performances du générateur en réduisant la puissance admissible maximum et en augmentant la largeur des impulsions du fait de l'augmentation de l'inductance.

L'invention a donc pour objet un générateur de type LTD, adapté pour délivrer des impulsions de forte puissance et de forme quadrangulaire dans lequel la pente du plateau de l'impulsion peut être réglée sans pour autant présenter des désavantages de la technique antérieure.

L'invention vise un tel générateur capable de conserver des performances de sortie optimales, en particulier en puissance de sortie.

L'invention vise également un tel générateur dans lequel le réglage de la forme de l'impulsion peut être réalisé sans modification et, en particulier, sans augmentation de l'inductance du générateur.

L'invention vise également un tel générateur dans lequel le réglage de la pente du plateau de l'impulsion est facile à réaliser, sans nécessiter d'usinage ou de modification des pièces du générateur.

L'invention vise encore un tel générateur dont le réglage peut être exécuté en fin de construction, tout en conservant un maximum de pièces standards.

Pour ce faire, l'invention concerne un générateur d'impulsions de forte puissance comprenant :
- une première série de modules de puissance, dits modules standards, comprenant chacun un commutateur, dit commutateur standard, muni d'une électrode de déclenchement, placé en série avec au moins un condensateur d'une première valeur de capacité, lesdits modules standards étant adaptés pour produire une impulsion à une première fréquence lors de la fermeture du commutateur,
- une deuxième série de modules de puissance, dits modules modifiés, comprenant chacun un commutateur, dit commutateur modifié, muni d'une électrode de déclenchement, placé en série avec au moins un condensateur d'une deuxième valeur de capacité, lesdits modules modifiés étant adaptés pour produire une impulsion à une deuxième fréquence lors de la fermeture du commutateur, ladite deuxième fréquence étant sensiblement triple de la première fréquence,
- un noyau central comportant un noyau magnétique comprenant au moins un anneau ferromagnétique, adapté pour réaliser une somme des impulsions produites par les modules standards et modifiés dans une charge concentrique au(x)dit(s) anneau(x), et obtenir une impulsion résultante sensiblement quadrangulaire comportant une rampe de montée, un plateau et une rampe de descente,
- un dispositif de déclenchement adapté pour commander les commutateurs standards et modifiés par un signal de déclenchement appliqué à leur électrode de déclenchement, ledit générateur étant caractérisé en ce que ledit signal de déclenchement est appliqué au travers d'une impédance de déclenchement reliée à l'électrode de déclenchement du commutateur, l'impédance de déclenchement des commutateurs modifiés, dite impédance modifiée, étant distincte de l'impédance de déclenchement des commutateurs standards, dite impédance standard, et en ce qu'une pente du plateau de l'impulsion dépend de la différence entre la valeur de l'impédance standard et celle de l'impédance modifiée.

En cherchant à résoudre un tout autre problème, en l'occurrence la gigue du temps de déclenchement des commutateurs, les inventeurs ont constaté que, de manière surprenante, une modification de l'impédance de déclenchement des commutateurs modifiés avait une influence sur la pente du plateau de l'impulsion. Les inventeurs ont alors constaté que le paramètre influent était la différence entre les valeurs des impédances de déclenchement des commutateurs modifiés et des commutateurs standards. Grâce à cet effet technique inattendu, il est maintenant possible de réaliser un générateur d'impulsion apte à fournir des impulsions quadrangulaires de forte puissance dont la pente du plateau est réglable, sans pour cela modifier la structure des modules de puissance. Le simple changement d'une impédance permet ainsi d'adapter le générateur d'impulsion en fonction de l'usage envisagé, par exemple générateur d'impulsion à plateau montant pour machine à striction axiale.

Avantageusement et selon l'invention, les impédances de déclenchement des commutateurs standards et modifiés comprennent chacune au moins une résistance de déclenchement, dites respectivement résistance standard et résistance modifiée. Ainsi, l'impédance de déclenchement d'un module (standard ou modifié) est essentiellement constituée d'une résistance pure, mais peut également comprendre une inductance en série, les résistances standards et modifiées présentant des valeurs différentes pour des valeurs d'inductances identiques ou différentes et vice versa. En pratique cependant, l'impédance de déclenchement est une résistance.

Avantageusement et selon l'invention, une différence supérieure à un seuil déterminé entre la résistance standard et la résistance modifiée détermine une pente croissante du plateau de l'impulsion. Le seuil dépend de nombreux paramètres tels que la structure du générateur (nombre de modules modifiés / nombre de modules standards), le type et la taille des commutateurs utilisés et le courant qui les traverse. En l'occurrence, le courant traversant les commutateurs des modules modifiés est plus faible (du fait des condensateurs de capacité moindre) que celui qui traverse les commutateurs standards. Le seuil de la différence entre les résistances standards et modifiées est déterminé par la valeur de la différence permettant d'obtenir un plateau de l'impulsion sensiblement horizontal. De même une différence inférieure à ce seuil déterminé entre la résistance standard et la résistance modifiée détermine une pente décroissante du plateau de l'impulsion.

Il est aussi possible d'utiliser des commutateurs différents entre les modules standards et modifiés En utilisant des commutateurs adaptés au courant traversant les modules respectifs, le seuil déterminé est en général nul et une résistance modifiée inférieure à la résistance standard permet d'obtenir une pente croissante du plateau de l'impulsion.

Ainsi, dans un générateur d'impulsion de la technique antérieure comportant par exemple six modules standards pour deux modules modifiés, le changement de deux résistances suffit à déterminer la forme des impulsions de sortie.

Avantageusement et selon l'invention, les résistances de déclenchement sont formées de barres de carbone aggloméré. En utilisant des résistances solides, en carbone aggloméré, il est possible d'obtenir une bonne précision des valeurs de résistance pour un coût modéré. Bien entendu, d'autres types de résistances, couramment employées dans ce type de générateurs peuvent être également utilisées, comme les résistances liquides formées de tubes remplis d'une solution électrolytique telle que le bromure de potassium ou le sulfate de cuivre ou encore des résistances formées d'un cylindre de matériau élastomère chargé de particules de carbone. Pour ces résistances, qu'elles soient liquides ou élastomères, la longueur, la section et la résistivité du matériau déterminent la valeur de la résistance.

Avantageusement et selon l'invention la pente du plateau de l'impulsion dépend également d'une différence des capacités parasites d'entrée des commutateurs standards et modifiés à l'instant de leur fermeture. Il a été également constaté que la capacité parasite de l'électrode de déclenchement, c'est-à-dire la capacité entre l'électrode de déclenchement et la masse, pouvait avoir, dans une moindre mesure, une influence sur la pente du plateau de l'impulsion. En effet, afin de fermer les commutateurs, le signal de déclenchement doit charger cette capacité jusqu'à atteindre une tension d'éclatement entre l'électrode de déclenchement et l'une des électrodes du commutateur. Cette charge intervenant au travers de la résistance de déclenchement, la valeur de cette capacité, comme celle de la résistance de déclenchement, détermine un délai entre l'application du signal de déclenchement et la fermeture du commutateur.

Avantageusement et selon l'invention, la capacité d'entrée des commutateurs standards et modifiés dépend de leur diamètre. Il a en effet été noté que la capacité d'entrée d'un commutateur croissait avec le diamètre de celui-ci, à tension de service égale. Il est donc possible d'intervenir sur la pente du plateau de l'impulsion générée en changeant le diamètre des commutateurs standards ou des commutateurs modifiés.

Avantageusement et selon l'invention, la pente du plateau de l'impulsion dépend d'une différence, entre les modules standards et modifiés, d'un délai entre le signal de déclenchement et l'établissement d'un courant d'impulsion entre les bornes du commutateur. Pour ce faire, l'impédance de déclenchement des modules standards et/ou des modules modifiés peut être globalement modifiée dès la sortie du dispositif de déclenchement de manière à distribuer à chaque série de modules un signal de déclenchement présentant un décalage temporel entre les modules standards et les modules modifiés.

D'autres moyens, tels que, par exemple, un tri et un appairage des commutateurs dans des modules standards ou modifiés en fonction de ce délai de déclenchement permettent de réaliser un générateur adapté à fournir des impulsions présentant une pente du plateau prédéterminée. Ainsi, quelle que soit la cause de ce délai de déclenchement, si les commutateurs des modules modifiés sont plus rapides que ceux des modules standards, la pente du plateau de l'impulsion est croissante et vice-versa.

L'invention concerne également un générateur d'impulsion de forte puissance caractérisé en combinaison par tout ou partie des caractéristiques mentionnées ci-dessus ou ci-après.

D'autres buts, caractéristiques et avantages de l'invention apparaîtront au vu de la description qui va suivre et des dessins annexés dans lesquels :
- la figure 1 représente schématiquement une vue de dessus, couvercle ôté, d'un générateur selon l'invention,
- la figure 2 est une vue en coupe d'un module de puissance d'un générateur selon l'invention,
- la figure 3 est un schéma électrique du dispositif de déclenchement d'un générateur selon l'invention,
- la figure 4 est un schéma illustrant les différentes formes d'impulsions susceptibles d'être obtenues avec un générateur selon l'invention, et
- la figure 5 est un schéma explicatif du fonctionnement d'un commutateur faisant partie d'un générateur selon l'invention.

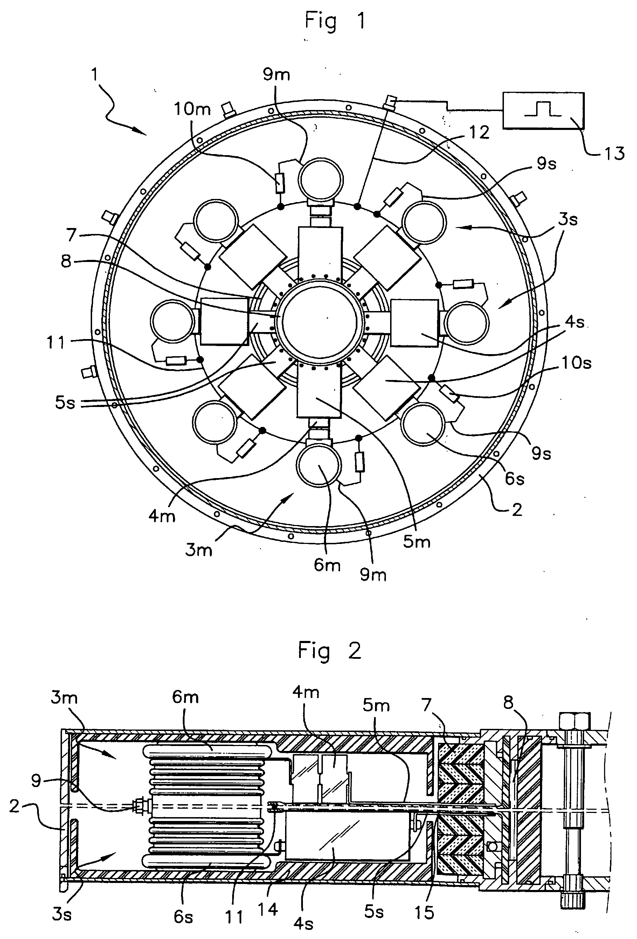

Le générateur 1 représenté à la figure 1 comporte une cavité 2 à l'intérieur de laquelle sont agencées, de manière symétrique et équiréparties, deux séries de modules de puissance. Le générateur 1 comprend une première série de six modules de puissance, dits modules standards, chacun d'eux étant repéré globalement par le repère 3s et une deuxième série de de modules de puissance, dits modules modifiés, chacun d'eux repérés globalement par le repère 3m.

Dans le présent texte, on distingue les modules standards et leurs éléments des modules modifiés et de leurs éléments en affectant les références désignant les premiers d'un indice *s* et les seconds d'un indice m. Ainsi, les modules de puissances standards sont notés 3s et les modules de puissance modifiés sont notés 3m. Lorsque la référence d'un module ou d'un élément n'est pas précisée par un indice s ou m, elle s'applique indifféremment aux modules standards ou modules modifiés. De même, dans un souci de simplification du texte, un élément appartenant à un module modifié peut être appelé « élément modifié » sans que cela signifie qu'il soit différent de l'élément correspondant appartenant à un module standard, appelé lui-même élément standard.

Sur le dessin de la figure 1, les modules de puissance sont disposés en étoile autour d'un noyau central, les modules 3m modifiés occupant les positions à midi et à six heures et les modules 3s standards se répartissant de part et d'autre des modules modifiés à un angle de 45° les uns des autres.

Chaque module, dont on a représenté à la figure 2 une coupe selon un plan radial du générateur de la figure 1, la coupe représentant en partie haute un module 3m modifié et en partie basse un module 3s standard, comporte un commutateur 6 (respectivement 6m pour le commutateur du module modifié et 6s pour le commutateur du module standard). Chaque commutateur comporte une enceinte isolante pressurisée, une électrode de décharge à chaque extrémité de l'enceinte et plusieurs électrodes intermédiaires dont l'une est une électrode 9 de déclenchement (respectivement 9m pour le commutateur -du module- modifié et 9s pour le commutateur -du module- standard). Chaque module comporte deux condensateurs 4 (respectivement 4m pour le condensateur modifié et 4s pour le condensateur standard) placés en série de part et d'autre du commutateur 6 et connectés par l'une de leurs électrodes à l'électrode de décharge correspondante du commutateur. Dans l'exemple représenté, le module 3s standard comporte deux condensateurs 4s d'une capacité de 8 nF sous une tension de service de 100 kV (dont un seul est représenté en partie basse de la figure 2) séparés par un plateau isolant 15. De même, le module 3m modifié comporte deux condensateurs 4m, constitués chacun de deux condensateurs en série d'une valeur de 1,7 nF sous une tension de service de 50 kV. Chaque condensateur 4s (respectivement 4m) est connecté, à l'opposé du commutateur, à un conducteur 5s (respectivement 5m) sous la forme d'une plaque métallique sensiblement rectangulaire, plaquée sur le plateau isolant 15 et s'étendant en direction du centre de la cavité 2. Les conducteurs 5 traversent ainsi un noyau central 7 constitué d'une pluralité d'anneaux en matériau ferromagnétique et forment une interface avec une charge 8 constituée d'un anneau rempli d'une solution électrolytique telle que le bromure de potassium.

Le plateau isolant 15 comporte sur sa périphérie externe un anneau conducteur, dit anneau de déclenchement 11, permettant de répartir un signal de déclenchement en provenance d'un dispositif de déclenchement 13 relié à l'anneau de déclenchement 11 par une ligne de déclenchement 12.

Les électrodes de déclenchement 9m des modules 3m modifiés et 9s des modules 3s standard sont reliées à l'anneau de déclenchement 11 par l'intermédiaire d'impédances de déclenchement 10m et 10s respectivement. Ces impédances de déclenchement sont constituées d'au moins une résistance 18, de préférence une résistance solide en carbone aggloméré, le cas échéant associée à une inductance. Dans le cas particulier du générateur décrit ici, les impédances de déclenchement sont constituées d'une résistance pure, notée résistance standard 18s pour les modules standards et résistance modifiée 18m pour les modules modifiés.

Les modules standards et modifiés ainsi que leur résistance de déclenchement sont contenus dans deux demi-coquilles 14 de la même matière que le plateau isolant 15 et baignent dans une huile isolante.

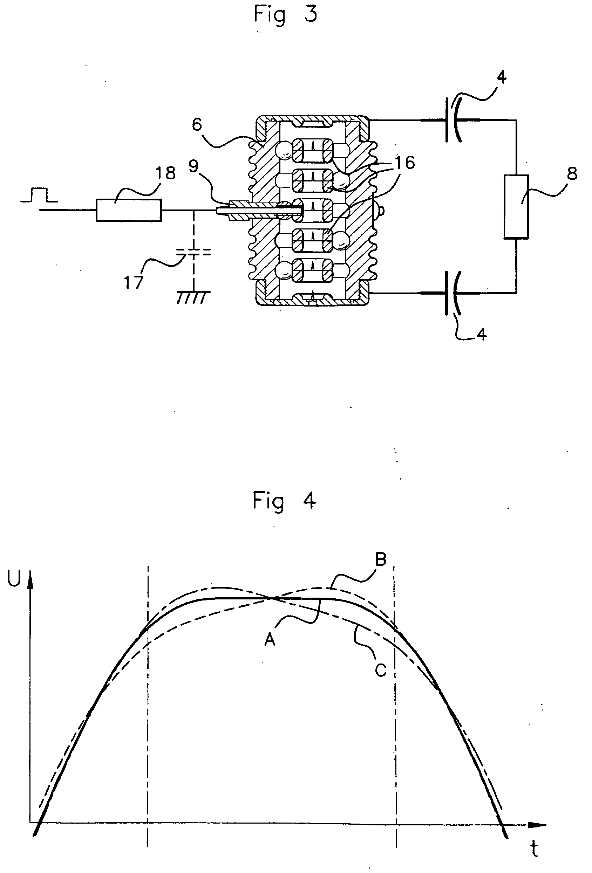

Le fonctionnement d'un des modules du générateur selon l'invention est détaillé ci-après en relation avec la figure 3.

Les condensateurs 4 sont chargés en parallèle par une tension respectivement de +100 kV pour l'un et - 100KV pour l'autre établissant ainsi aux bornes des commutateurs 6 une différence de potentiel de 200 kV. Un signal de déclenchement émis par le dispositif de déclenchement 13 est transmis par l'intermédiaire de l'anneau de déclenchement 11 à la résistance de déclenchement 10 et l'électrode de déclenchement 9. Le signal de déclenchement, en général sous la forme d'une impulsion de quelques dizaines de kilovolts, entraîne une modification de la répartition des potentiels à l'intérieur du commutateur 6 et provoque la fermeture de celui-ci. Dès que le commutateur 6 est fermé, un courant s'établit au travers du commutateur et l'énergie stockée dans les condensateurs 4 génère un courant circulant dans la charge 8.

On a cependant constaté qu'il se produisait un délai entre le signal de déclenchement et l'établissement du courant dans le commutateur, et ce tant dans les modules standards que dans les modules modifiés. En outre, ce délai présente une durée souffrant d'une variation aléatoire (gigue) de quelques nanosecondes. C'est en recherchant une solution à ce phénomène que les inventeurs ont constaté, en utilisant différentes valeurs de résistance de déclenchement sur les modules modifiés, que l'impulsion résultante fournie par le générateur présentait une pente variable du plateau de l'impulsion.

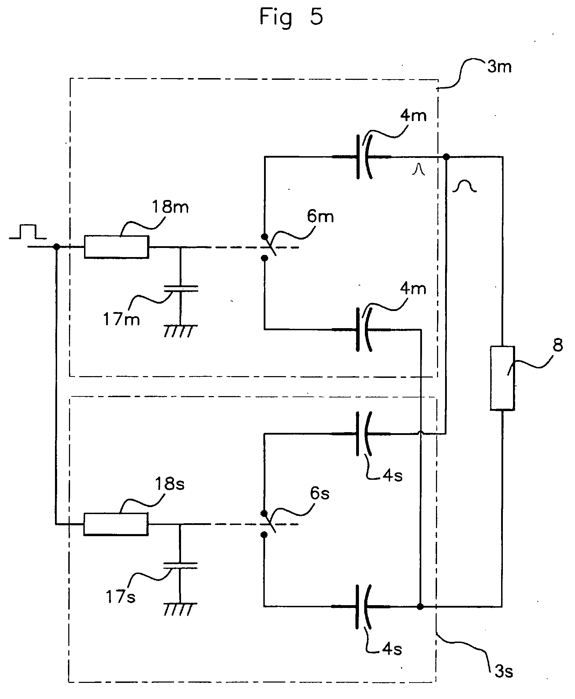

L'analyse *a posteriori* de ce phénomène a conduit à l'interprétation suivante : le commutateur 6 se comporte comme s'il existait une capacité 17 « parasite » de déclenchement entre l'électrode de déclenchement 9 et la masse. Bien entendu, la capacité 17 représentée sur le schéma des figures 3 et 5 n'est qu'une représentation commode, la capacité parasite réelle étant répartie entre l'électrode de déclenchement et les deux bornes du commutateur 6 et entre ces dernières et la masse. L'ensemble résistance de déclenchement 10 et capacité 17 génère alors une constante de temps entraînant un délai entre l'application du signal de déclenchement et la fermeture effective du commutateur 6.

De plus, lorsque ce délai affecte dans le même sens (retard ou avance) les commutateurs 6m modifiés par rapport aux commutateurs 6s standards, l'impulsion générée par les commutateurs modifiés présente un déphasage par rapport à celle générée par les commutateurs standard. Ce déphasage entraîne une pente du plateau de l'impulsion, comme représenté sur la figure 4. Sur cette figure, on a représenté en trait plein, repérée par la lettre A, la forme de l'impulsion obtenue par un générateur dans lequel le délai de déclenchement des modules standard est égal au délai de déclenchement des modules modifiés. On peut constater que le plateau de cette impulsion (entre les deux traits repères verticaux) est sensiblement horizontal. On a de même représenté en tirets et repéré par la lettre B la forme d'une impulsion obtenue lorsque le délai de déclenchement des modules standards est supérieur à celui des modules modifiés (pente ascendante) et, en trait mixte, repérée par la lettre C, la forme d'une impulsion obtenue lorsque le délai de déclenchement des modules modifiés est supérieur à celui des modules standards.

La représentation schématique du générateur selon l'invention faite à la figure 5 permet de mieux comprendre le fonctionnement du générateur. Sur cette figure, on a représenté en 3m un module modifié représentant la somme des modules modifiés du générateur et en 3s un module standard représentant la somme des modules standards du générateur.

Lorsque le signal de déclenchement est délivré au module standard 3s, la résistance de déclenchement 18s et la capacité parasite d'entrée 17s s du module forment un circuit RC propre à entrainer un retard à la fermeture du commutateur 6s, retard dépendant du produit de la valeur de la résistance de déclenchement et de la capacité parasite d'entrée. Lorsque le commutateur 6s se ferme, les condensateurs 4s se déchargent au travers du commutateur dans la charge 8, formant une première impulsion à une première fréquence dépendant de la valeur des condensateurs 4s.

Le fonctionnement est identique pour le module modifié 3m. Le commutateur 6m se ferme avec un retard dépendant de la résistance de déclenchement 18m et de la capacité parasite 17m, et entraîne la génération d'une deuxième impulsion à une deuxième fréquence dépendant de la valeur des condensateurs 4m. Celle-ci est prévue pour que la deuxième fréquence soit le triple de la première fréquence.

Les deux impulsions sont combinées dans la charge 8 pour générer une impulsion résultante quadrangulaire. La différence de retard de fermeture des modules modifiés et standard entraîne un déphasage de ces impulsions l'une par rapport à l'autre et, en application du théorème de Fourier conditionne la pente du plateau de l'impulsion résultante.

On a cependant noté que la valeur des capacités 17m et 17s est très faible, de l'ordre de 15 pF et qu'il est difficile de la faire varier, sinon en faisant varier le diamètre des commutateurs. Il est donc possible de jouer sur la valeur de ces capacités en utilisant des commutateurs de diamètre différent entre les modules standards et des modules modifiés. Cependant, cette variation est limitée par des contraintes d'encombrement, l'augmentation du diamètre d'un commutateur entraînant l'augmentation du diamètre du générateur tout entier pour conserver une distance d'isolement entre les commutateurs.

Il est donc préférable de modifier la valeur des résistances de déclenchement pour obtenir la pente désirée du plateau de l'impulsion. À titre d'exemple, pour des commutateurs 6s standards de 140 mm de diamètre et des commutateurs 6m modifiés de 78 mm de diamètre, et pour une résistance de déclenchement 18s des modules standards de 500 ohms, l'utilisation d'une résistance de déclenchement 18m des modules modifiés de 330 ohms entraîne une pente croissante du plateau de l'impulsion, une résistance de déclenchement 18m de 540 ohms donne une pente sensiblement horizontale et une résistance de déclenchement 18m de 1000 ohms donne une pente décroissante. En utilisant des commutateurs 6m modifiés identiques aux commutateurs 6s standards, c'est-à-dire de diamètre 140 mm, des résistances de déclenchement standards de 540 ohms et modifiées de 330 ohms conduisent à une pente sensiblement horizontale.

Bien entendu, la description ci-dessus qui décrit l'invention en relation avec un générateur LTD particulier est donnée à titre d'exemple illustratif uniquement et l'homme du métier pourra y apporter de nombreuses modifications sans sortir de la portée de l'invention, comme par exemple appliquer l'invention pour différentes géométries de générateur, comportant un nombre de modules par cavité différent (par exemple 40 modules par cavité), un rapport entre le nombre de modules modifiés et standards différent, ou encore un générateur constitué de plusieurs cavités en série. De même, les modules de puissance peuvent être à double polarité (±100KV avec le commutateur en série entre les condensateurs, comme dans l'exemple illustré) ou bien à simple polarité avec un seul condensateur en série avec le commutateur, alimentés par une ou des tensions différentes (50KV), etc. Les modules peuvent être isolés par un bain d'huile comme dans l'exemple représenté ou bien par un gaz tel que de l'air sec pressurisé ou autre.

## Revendications

1. Générateur (1) d'impulsions de forte puissance comprenant :
- une première série de modules de puissance, dits modules (3s) standards, comprenant chacun un commutateur, dit commutateur (6s) standard, muni d'une électrode de déclenchement (9s), placé en série avec au moins un condensateur (4s) d'une première valeur de capacité, lesdits modules standards étant adaptés pour produire une impulsion à une première fréquence lors de la fermeture du commutateur,
- une deuxième série de modules de puissance, dits modules (3m) modifiés, comprenant chacun un commutateur, dit commutateur (6m) modifié, muni d'une électrode de déclenchement (9m), placé en série avec au moins un condensateur (4m) d'une deuxième valeur de capacité, lesdits modules modifiés étant adaptés pour produire une impulsion à une deuxième fréquence lors de la fermeture du commutateur, ladite deuxième fréquence étant sensiblement triple de la première fréquence,
- un noyau central comportant un noyau magnétique comprenant au moins un anneau ferromagnétique (7) adapté pour réaliser une somme des impulsions produites par les modules (3s) standards et (3m) modifiés dans une charge (8) concentrique au(x)dit(s) anneau(x), et obtenir une impulsion résultante sensiblement quadrangulaire comportant une rampe de montée, un plateau et une rampe de descente,
- un dispositif (13) de déclenchement adapté pour commander les commutateurs (6s ; 6m) standards et modifiés par un signal de déclenchement appliqué à leur électrode de déclenchement (9s ; 9m),
ledit générateur (1) étant **caractérisé en ce que** ledit signal de déclenchement est appliqué aux commutateurs au travers d'une impédance de déclenchement (10m ; 10s) reliée à l'électrode de déclenchement du commutateur, l'impédance de déclenchement des commutateurs modifiés, dite impédance modifiée (10m), étant distincte de l'impédance de déclenchement des commutateurs standards, dite impédance standard (10s), et **en ce qu'**une pente du plateau de l'impulsion dépend de la différence entre la valeur de l'impédance standard et celle de l'impédance modifiée.

2. Générateur selon la revendication 1, **caractérisé en ce que** les impédances (10s ; 10m) de déclenchement des commutateurs (6s) standards et (6m) modifiés comprennent chacune au moins une résistance de déclenchement (18s ;18m), dites respectivement résistance standard (18s) et résistance modifiée (18m).

3. Générateur selon l'une des revendications 1 ou 2, **caractérisé en ce qu'**une une différence supérieure à un seuil déterminé entre la résistance standard (18s) et la résistance modifiée (18m) détermine une pente croissante du plateau de l'impulsion.

4. Générateur selon l'une des revendications 1 à 3, **caractérisé en ce que** les résistances de déclenchement (18m ; 18s) sont formées de barres de carbone aggloméré.

5. Générateur selon l'une des revendications 1 à 3, **caractérisé en ce que** les résistances de déclenchement sont des résistances liquides formées de tubes remplis d'une solution électrolytique.

6. Générateur selon l'une des revendications 1 à 3, **caractérisé en ce que** les résistances de déclenchement sont formées d'un cylindre de matériau élastomère chargé de particules de carbone.

7. Générateur selon l'une des revendications 1 ou 2, **caractérisé en ce que** la pente du plateau de l'impulsion dépend également d'une différence des capacités (17s ; 17m) parasites d'entrée des commutateurs (6s ; 6m) standards et modifiés à l'instant de leur fermeture.

8. Générateur selon la revendication 7 **caractérisé en ce que** ladite capacité (17s ; 17m) parasite d'entrée des commutateurs standard et modifiés dépend du diamètre des commutateurs utilisés dans les modules standard et modifiés, respectivement.

9. Générateur selon l'une des revendications 1 ou 2, **caractérisé en ce qu'**il comporte des moyens propres à déterminer un délai, dit délai de déclenchement, entre le signal de déclenchement et l'établissement d'un courant d'impulsion entre les bornes des commutateurs (6s, 6m) de manière à régler la pente du plateau de l'impulsion en fonction d'une différence entre les délais de déclenchement des commutateurs des modules (3s) standards et (3m) modifiés.

## Patentansprüche

1. Generator (1) für Hochleistungsimpulse, umfassend:
- eine erste Reihe von Leistungsmodulen, bezeichnet als Standardmodule (3s), umfassend jeweils einen Schalter, bezeichnet als Standardschalter (6S), ausgestattet mit einer Auslöseelektrode (9s), die mit mindestens einem Kondensator (4s) mit einem ersten Kapazitätswert in Reihe geschaltet ist, wobei die Standardmodule ausgelegt sind, um beim Schließen des Schalters einen Impuls mit einer ersten Frequenz zu erzeugen,
- eine zweite Reihe von Leistungsmodulen, bezeichnet als modifizierte Module (3m), umfassend jeweils einen Schalter, bezeichnet als modifizierter Schalter (6m), ausgestattet mit einer Auslöseelektrode (9m), die mit mindestens einem Kondensator (4m) mit einem zweiten Kapazitätswert in Reihe geschaltet ist, wobei die modifizierten Module ausgelegt sind, um beim Schließen des Schalters einen Impuls mit einer zweiten Frequenz zu erzeugen, wobei die zweite Frequenz im Wesentlichen dreimal die erste Frequenz ist,
- einen zentralen Kern, der einen Magnetkern mit mindestens einem ferromagnetischen Ring (7) umfasst, ausgelegt, um eine Summe der Impulse durchzuführen, die von den Standard- (3s) und modifizierten Modulen (3m) in einer konzentrischen Last (8) zu dem/den Ring(en) erzeugt werden, und einen sich ergebenden im Wesentlichen vierseitigen Impuls zu erhalten, umfassend eine Anstiegsrampe, ein Plateau und eine Abstiegsrampe,
- eine Auslösevorrichtung (13), die ausgelegt ist, um die Standard- und modifizierten Schalter (6s; 6m) durch ein Auslösesignal zu steuern, das an ihre Auslöseelektrode (9s; 9m) angelegt ist.
wobei der Generator(1) **dadurch gekennzeichnet ist, dass** das Auslösesignal an die Schalter mit Hilfe einer Auslöseimpedanz (10m, 10s) angelegt ist, die mit der Auslöseelektrode des Schalters verbunden ist, wobei die Auslöseimpedanz der modifizierten Schalter, bezeichnet als modifizierte Impedanz (10m), verschieden von der Auslöseimpedanz der Standardschalter, bezeichnet als Standardimpedanz (10s), ist, und dadurch, dass die Neigung des Impulsplateaus von der Differenz zwischen dem Wert der Standardimpedanz und demjenigen der modifizierten Impedanz abhängt.

2. Generator nach Anspruch 1, **dadurch gekennzeichnet, dass** die Auslöseimpedanzen (10s; 10m) der Standard- (6s) und modifizierten Schalter (6m) jeweils mindestens einen Auslösewiderstand (18s; 18m) umfassen, jeweils bezeichnet als Standardwiderstand (18s) und modifizierter Widerstand (18m).

3. Generator nach einem der Ansprüche 1 oder 2, **dadurch gekennzeichnet, dass** eine Differenz, die größer als ein Schwellenwert ist, der zwischen dem Standardwiderstand (18s) und dem modifizierten Widerstand (18m) bestimmt ist, eine zunehmende Neigung des Impulsplateaus bestimmt.

4. Generator nach einem der Ansprüche 1 bis 3, **dadurch gekennzeichnet, dass** die Auslösewiderstände (18m, 18s) aus Stäben aus Kohlenstoff-Cluster gebildet sind.

5. Generator nach einem der Ansprüche 1 bis 3, **dadurch gekennzeichnet, dass** die Auslösewiderstände flüssige Widerstände sind, gebildet aus Rohren, die mit einer Elektrolytlösung gefüllt sind.

6. Generator nach einem der Ansprüche 1 bis 3, **dadurch gekennzeichnet, dass** die Auslösewiderstände aus einem Zylinder aus elastomerem Material, geladen mit Kohlenstoffpartikeln, gebildet sind.

7. Generator nach einem der Ansprüche 1 oder 2, **dadurch gekennzeichnet, dass** die Neigung des Impulsplateaus auch von einer Differenz der parasitären Eingangskapazitäten (17s, 17m) der Standard- und modifizierten Schalter (6s; 6m) im Augenblick ihrer Schließung abhängt.

8. Generator nach Anspruch 7, **dadurch gekennzeichnet, dass** die parasitäre Eingangskapazität (17s; 17m) der Standard- und modifizierten Schalter vom Durchmesser der Schalter abhängt, die in den Standard-bzw. modifizierten Modulen verwendet werden.

9. Generator nach einem der Ansprüche 1 oder 2, **dadurch gekennzeichnet, dass** er Mittel umfasst, die geeignet sind, um eine Verzögerung, bezeichnet als Auslöseverzögerung, zwischen dem Auslösesignal und dem Einrichtungssignal eines Impulsstroms zwischen den Klemmen der Schalter (6s, 6m) zu bestimmen, um die Neigung des Impulsplateaus je nach einer Differenz zwischen den Auslöseverzögerungen der Schalter der Standard- (3s) und modifizierten (3m) Module einzustellen.

## Claims

1. - High-power pulse generator (1) comprising:
- a first series of power modules, named standard modules (3s), each comprising a switch, named standard switch (6s), provided with a trigger electrode (9s), positioned in series with at least one capacitor (4s) with a first capacitance value, said standard modules being designed to produce a pulse at a first frequency when said switch is closed;
- a second series of power modules, named modified modules (3m), each comprising a switch, named modified switch (6m), provided with a trigger electrode (9m), positioned in series with at least one capacitor (4m) with a second capacitance value, said modified modules being designed to produce a pulse at a second frequency when said switch is closed, said second frequency being substantially three times that of the first frequency;
- a central core comprising a magnetic core that comprises at least one ferromagnetic ring (7) designed to add the pulses produced by said standard (3s) and modified (3m) modules in a load (8) concentric to said ring(s) and to obtain a substantially quadrangular shaped resulting pulse comprising a rising edge, a plateau and a falling edge;
- a trigger device (13) designed to control said standard and modified switches (6s; 6m) by a trigger signal applied to their trigger electrode (9s; 9m),
said generator (1) being **characterised in that** said trigger signal is applied to said switches through a trigger impedance (10m; 10s) connected to the trigger electrode of the switch, with the trigger impedance of said modified switches, named modified impedance (10m), being distinct from the trigger impedance of said standard switches, named standard impedance (10s), and **in that** a slope of the pulse plateau depends on the difference between the value of said standard impedance and that of said modified impedance.

2. - Generator according to claim 1, **characterised in that** said trigger impedances (10s; 10m) of said standard (6s) and modified (6m) switches each comprise at least one trigger resistance (18s; 18m), named standard resistance (18s) and modified resistance (18m), respectively.

3. - Generator according to claim 1 or 2, **characterised in that** a difference greater than a determined threshold between said standard resistance (18s) and said modified resistance (18m) determines a rising slope of the pulse plateau.

4. - Generator according to any one of claims 1 to 3, **characterised in that** the trigger resistors (18m; 18s) are formed from agglomerated carbon bars.

5. - Generator according to any one of claims 1 to 3, **characterised in that** said trigger resistors are liquid resistors formed from tubes filled with an electrolytic solution.

6. - Generator according to any one of claims 1 to 3, **characterised in that** said trigger resistors are formed from a cylinder of elastomer material loaded with carbon particles.

7. - Generator according to claim 1 or 2, **characterised in that** the slope of the pulse plateau also depends on a difference in the parasitic input capacitances (17s; 17m) of said standard and modified switches (6s; 6m) at the moment they are closed.

8. - Generator according to claim 7, **characterised in that** said parasitic input capacitance (17s; 17m) of said standard and modified switches depends on the diameter of the switches used in said standard and modified modules, respectively.

9. - Generator according to claim 1 or 2, **characterised in that** it comprises means designed to determine a delay, named trigger delay, between the trigger signal and the formation of a pulse current between the terminals of said switches (6s; 6m) so as to adjust the slope of the pulse plateau as a function of a difference between the trigger delays of the switches of said standard (3s) and modified (3m) modules.
